# EUROPEAN PATENT SPECIFICATION

(11) **EP 1 154 559 B1**
(45) Date of publication and mention of the grant of the patent: **22.10.2003**
(21) Application number: 01302222.3
(22) Date of filing: 12.03.2001
(51) Int. Cl.: H03B 5/06

(54) **Oscillator**
Oszillator
Oscillateur

(30) Priority: 30.03.2000 JP 2000097888
(43) Date of publication of application: 14.11.2001
(73) Proprietor: ALPS ELECTRIC CO., LTD., Ota-ku Tokyo 145 (JP)
(72) Inventor: Noumi, Hiroki, c/o Alps Electric Co. Ltd., Tokyo 145 (JP)
(74) Representative: Kensett, John Hinton

(56) References cited:
- EP-A- 0 803 972
- US-A- 4 199 734
- US-A- 4 859 969
- US-A- 5 263 197

## Description

### BACKGROUND OF THE INVENTION

### Field of the Invention

The present invention relates to an oscillator that is provided with an oscillating circuit and an amplifying circuit to amplify and output oscillation signals in two frequency bands in which a frequency ratio is in almost the doubled condition.

### Description of the Related Art

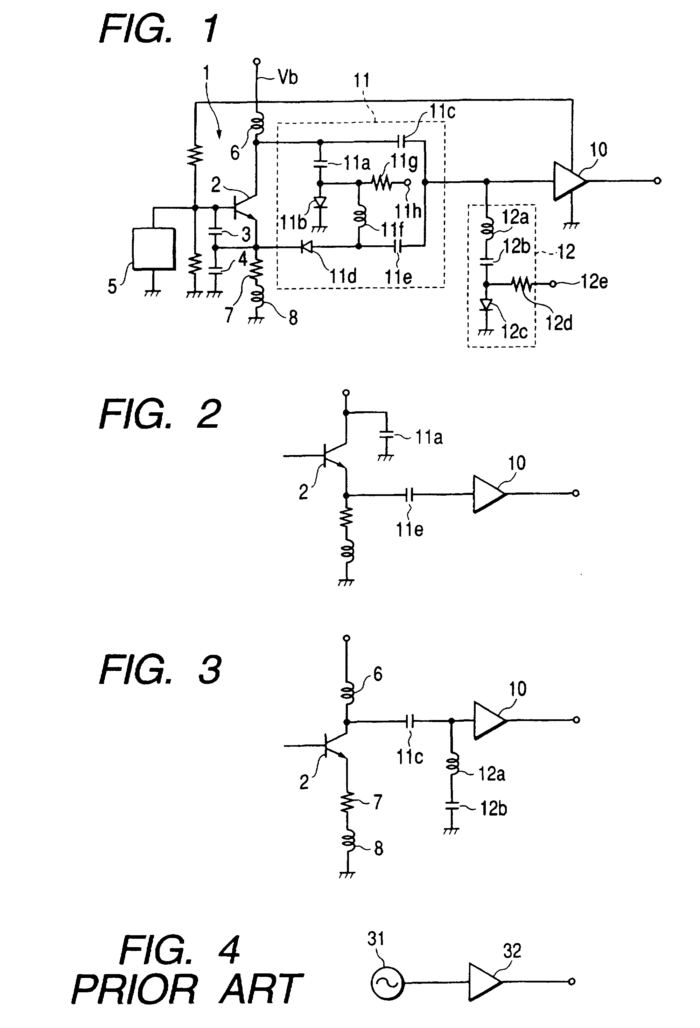

An oscillator of the related art will be explained with reference to Fig. 4. An oscillating circuit 31 includes therein a resonance circuit (not illustrated) and oscillates in any frequency band of 900 MHz band or 1800 MHz band through the switching of the resonance frequency of such resonance circuit. The oscillation signal is outputted from the emitter or base of the oscillating transistor (not illustrated) forming the oscillating circuit 31 and is then inputted to an amplifying circuit 32. The amplifying circuit 32 is structured as a tuning amplifying circuit that is tuned to 900 MHz band or 1800 MHz band.

Switching of the oscillation frequency band of the oscillating circuit 31 and the switching of the tuning amplifying frequency band of the amplifying circuit 32 are interlocked and the oscillation signals of the oscillating frequency bands are outputted from the amplifying circuit 32.

However, in an oscillator of the related art, oscillation is performed in the couple of frequency bands where the frequency ration is maintained in the doubled condition with only one oscillation circuit. Therefore sufficient oscillating condition cannot be attained in two frequency bands and stable oscillation has been impossible because the oscillating condition in one frequency band becomes insufficient.

Further information, in particular with regard to dual band oscillators, can be found in EP-A-0 803 972.

### SUMMARY OF THE INVENTION

Therefore, an object of the present invention is to provide an oscillator that can stably oscillate in one frequency band and obtains, in the sufficient signal level, the oscillation signal of two frequency bands where the frequency ratio is in the doubled condition.

According to an aspect of the present invention, there is provided an oscillator, comprising: an oscillating circuit that oscillates in a predetermined frequency band including a basic wave and at least a secondary harmonic wave; a signal attenuating means for attenuating only the basic wave; and an amplifying circuit for outputting the basic wave or the secondary harmonic wave of an oscillation signal by amplifying the oscillation signal including the basic wave and the secondary harmonic wave outputted from the oscillating circuit; characterised in that the input terminal of the amplifying circuit is provided with the signal attenuating means, and in that the signal attenuating means is turned OFF to input the oscillation signal into the amplifying circuit when the basic wave is outputted from the amplifying circuit, and the signal attenuating means is turned ON to attenuate the basic wave when the secondary harmonic wave is outputted from the amplifying circuit.

Preferably, the oscillating circuit includes an oscillating transistor, a first switch diode is connected between the collector of the oscillating transistor and the ground, and the emitter of the oscillating transistor is coupled with the input terminal of the amplifying circuit by a second switch diode; both the first switch diode and the second switch diode are turned ON to input the oscillation signal from the emitter of the oscillating transistor to the amplifying circuit when the basic wave is outputted from the amplifying circuit; and both the first switch diode and the second switch diode are turned OFF to input the oscillation signal from the collector of the oscillating transistor to the amplifying circuit when the secondary harmonic wave is outputted from the amplifying circuit.

Preferably, the signal attenuating means is an oscillator according to claim 1 or 2, wherein the signal attenuating means comprises a serial resonance circuit that resonates with the frequency of the basic wave and a third switch diode in aerial connection with the serial resonance circuit, and wherein the signal attenuating means is connected between the input terminal of the amplifying circuit and the ground to turn ON the third switch diode operationally in association with the first switch diode and the second switch diode only when the amplifier outputs the secondary harmonic wave.

An embodiment of the present invention, will now be described by way of example only, with reference to the accompanying diagrammatic drawings in which:
Fig. 1 is a circuit diagram illustrating structure of an oscillator of the present invention.
Fig. 2 is an equivalent circuit diagram of the oscillator of the present invention.
Fig. 3 is an equivalent circuit diagram of the oscillator of the present invention.
Fig. 4 is a circuit diagram illustrating the structure of an oscillator of the related art.

First, the figure illustrates a circuit structure of the oscillator of the present invention. An oscillating circuit 1 comprises an oscillating transistor 2, feedback capacitors 3, 4 and a resonance circuit 5 or the like, and the resonance circuit 5 is connected to a base of the oscillating transistor 2. A voltage Vb is applied to a collector of the oscillating transistor 2 via a choke inductor 6, while an emitter is grounded with a serial circuit of a bias resistor 7 and an inductance element 8.

The oscillating circuit 1 oscillates in one frequency band (for example, 900 MHz band) and the oscillation signal is outputted from the collector and emitter of the oscillating transistor 2. Frequency of the oscillation signal may be varied with a control voltage to be applied to a varactor diode (not illustrated) provided within the resonance circuit 5.

Moreover, a coupling circuit 11 to input the oscillation signal to the amplifying circuit 10 is provided between the oscillating circuit 1 and the amplifying circuit 10, and the signal attenuating means 12 is provided at the input terminal of the amplifying circuit 10.

In the coupling circuit 11, the collector of oscillating transistor 2 is connected to the ground by a serial circuit of the DC-cut capacitor 11a and a first switch diode 11b, and also to the amplifying circuit 10 by a first coupling capacitor 11c. The cathode of first switch diode 11b is grounded. The DC-cut capacitor 11a has a very low impedance at the frequency of the oscillation signal.

On the other hand, the emitter of oscillating transistor 2 and the input terminal of amplifying circuit 10 are coupled with each other through a serial circuit of the second switch diode 11d and second coupling capacitor 11e. The cathode of second switch diode 11d is connected to the emitter of oscillating transistor 2.

The anode of the first switch diode 11b and the anode of the second switch diode lid are connected with each other through an inductance element 11f for cutting off the high frequency element and are then connected to a first switch terminal llh via a power feeding resistor 11g.

The signal attenuating means 12 is formed of a serial circuit consisting of an inductance element 12a, a capacitor 12b and a third switch diode 12c, and the cathode of third switch diode 12c is grounded. A resonance frequency of a serial resonance circuit of the inductance element 12a and capacitor 12b is almost equal to the frequency of basic wave of the oscillation signal. The anode of the third switch diode 12c is connected to the second switch terminal 12e via the power feeding resistor 12d.

In above structure, a high level switch voltage or a low level switch voltage is applied to a first switch terminal llh and a second switch terminal 12e, but when the high level switch voltage is applied to the first switch terminal llh, the low level switch voltage is applied to the second switch terminal. On the contrary, when the low level switch voltage is applied to the first switch terminal llh, the high level switch voltage is applied to the second switch terminal.

Moreover, the collector and emitter of the oscillating transistor 2 output the oscillation signal. However, since the frequency of basic wave of the oscillation signal is in 900 MHz band, the collector and emitter also output the harmonic wave of the oscillation signal.

When the high level switch voltage is applied to the first switch terminal 11h, both the first switch diode 11b and the second switch diode 11d turn ON and the third switch diode 12c turns OFF. As a result, the equivalent circuit of Fig. 2 can be attained and the collector of oscillating transistor 2 is grounded by the capacitor 11a in a high frequency manner and the oscillating circuit 1 is converted to the grounded collector type oscillating circuit.

Since the third switch diode 12c is turned OFF, the basic wave and harmonic wave (including the secondary harmonic wave) of the oscillation signal outputted from the emitter of oscillating transistor 2 are inputted to the amplifying circuit 10 via the third switch diode lid and second coupling capacitor 11e without attenuation with the signal attenuating means 12.

Since the basic wave level of the oscillation signal is higher than the harmonics wave level, the amplifying circuit 10 provides the sufficiently amplified basic wave.

On the other hand, when the low level switch voltage is applied to the first switch terminal llh, both the first switch diode 11b and the second switch diode 11d turn OFF and the third switch diode 12c turns ON. As a result, both the basic wave and the harmonic wave (including the secondary harmonic wave) of the oscillation signal outputted from the emitter of oscillating transistor 2 are rejected with the second switch diode and is not inputted to the amplifying circuit 10. As illustrated in Fig. 3, both the basic wave and the harmonic wave (including the secondary harmonic wave) of the oscillation signal outputted from the collector are then inputted to the amplifying circuit 10 via the first coupling capacitor.

In this case, since the third switch diode 12c is turned ON, only the harmonic wave is inputted to the amplifying circuit 10 and is then amplified therein. Since the basic wave is not inputted to the amplifying circuit 10, its harmonic wave is not generated in the amplifying circuit 10. Therefore, since the amplified harmonic wave level is higher than the harmonic wave level generated in the amplifying circuit 10 with the basic wave that is inputted to the amplifying circuit10 from the oscillating circuit 1, the high level secondary harmonic wave can be outputted. Moreover, the oscillation signal level outputted from the collector of oscillating transistor 2 is generally higher than that outputted from the emitter thereof, the higher level secondary harmonic wave can be outputted from the amplifying circuit 10.

As explained above, since the oscillator of the present invention comprises an oscillating circuit that oscillates in the predetermined frequency band, a signal attenuating means, and an amplifying circuit for amplifying and outputting the basic wave or secondary harmonic wave of the oscillation signal and also includes the signal attenuating means at the input terminal of the amplifying circuit, to thereby attenuate the basic wave by the signal attenuating means when the amplifying circuit outputs the secondary harmonic wave, the oscillation signals of two frequency bands where the frequency ratio is in the doubled condition can be outputted in higher level by stably oscillating the oscillating circuit in one frequency band.

Moreover, when the amplifying circuit outputs the basic wave, the oscillation signal is inputted to the amplifying circuit from the emitter of the oscillating transistor and when the amplifying circuit outputs the secondary harmonic wave, the oscillation signal is inputted to the amplifying circuit from the collector of oscillating transistor. Therefore, high level harmonic wave can be outputted from the amplifier.

Moreover, since the first switch diode is connected between the collector of oscillating transistor and the ground, the emitter thereof is coupled to the input terminal of amplifying circuit by the second switch diode, and both the first switch diode and the second switch diode are turned ON or OFF, the oscillation signal can be outputted from any one of the collector and emitter.

Moreover, since the signal attenuating means is constituted of the serial resonance circuit that resonates in the frequency of basic wave and the third switch diode, the signal attenuating means is connected between the input terminal of the amplifying circuit and the ground, and the third switch diode is turned ON only when the amplifier outputs the secondary harmonic wave, the basic wave can be attenuated easily.

## Claims

1. An oscillator, comprising: an oscillating circuit (1) that oscillates in a predetermined frequency band including a basic wave and at least a secondary harmonic wave; a signal attenuating means (12) for attenuating only the basic wave; and an amplifying circuit (10) for outputting the basic wave or the secondary harmonic wave of an oscillation signal by amplifying the oscillation signal including the basic wave and the secondary harmonic wave outputted from the oscillating circuit; **characterised in that** the input terminal of the amplifying circuit is provided with the signal attenuating means, and **in that** the signal attenuating means is turned OFF to input the oscillation signal into the amplifying circuit when the basic wave is outputted from the amplifying circuit, and the signal attenuating means is turned ON to attenuate the basic wave when the secondary harmonic wave is outputted from the amplifying circuit.

2. An oscillator according to claim 1, wherein the oscillating circuit includes an oscillating transistor (2), a first switch diode (llb) is connected between the collector of the oscillating transistor and the ground, and the emitter of the oscillating transistor is coupled with the input terminal of the amplifying circuit by a second switch diode (11d); both the first switch diode and the second switch diode are turned ON to input the oscillation signal from the emitter of the oscillating transistor to the amplifying circuit when the basic wave is outputted from the amplifying circuit; and both the first switch diode and the second switch diode are turned OFF to input the oscillation signal from the collector of the oscillating transistor to the amplifying circuit when the secondary harmonic wave is outputted from the amplifying circuit.

3. An oscillator according to claim 1 or 2, wherein the signal attenuating means comprises a serial resonance circuit that resonates with the frequency of the basic wave, and a third switch diode (12c) in a serial connection with the serial resonance circuit, and wherein the signal attenuating means is connected between the input terminal of the amplifying circuit and the ground to turn ON the third switch diode operationally in association with the first switch diode and the second switch diode only when the amplifier outputs the secondary harmonic wave.

## Patentansprüche

1. Oszillator mit: Oszillatorschaltkreis (1), der in einem vorher festgelegten Frequenzbereich oszilliert, welcher eine Basisschwingung und mindestens eine sekundäre Oberschwingung einschließt; einer Signaldämpfungseinrichtung (12) zur Dämpfung nur der Basisschwingung sowie eine Verstärkerschaltung (10) für die Ausgabe der Basisschwingung oder der sekundären Oberschwingung eines Oszillationssignals durch Verstärken des Oszillationssignals einschließlich der Basisschwingung und der sekundären Oberschwingung, die vom Oszillatorschaltkreis ausgegeben worden sind; **dadurch gekennzeichnet, dass** der Eingangsanschluss der Verstärkerschaltung mit der Signaldämpfungseinrichtung ausgestattet ist, und dadurch, dass die Signaldämpfungseinrichtung AUS-geschaltet ist, um das Oszillationssignal in die Verstärkerschaltung einzugeben, sobald die Basisschwingung von der Verstärkerschaltung ausgegeben wird, und dass die Signaldämpfungseinrichtung EIN -geschaltet ist, um die Basisschwingung zu dämpfen, sobald die sekundäre Oberschwingung von der Verstärkerschaltung ausgegeben wird.

2. Oszillator nach Anspruch 1, wobei der Oszillatorschaltkreis einen Oszillationstransistor (2) einschließt; eine erste Verteilerdiode (11b) ist zwischen dem Kollektor des Oszillationstransistors und der Masse verbunden, und der Emitter des Oszillationstransistors ist mit dem Eingangsanschluss der Verstärkerschaltung durch eine zweite Verteilerdiode (11d) gekoppelt; sowohl die erste Verteilerdiode als auch die zweite Verteilerdiode sind zur Eingabe des Oszillationssignals vom Emitter des Oszillationstransistors hin zur Verstärkerschaltung EIN -geschaltet, wenn die Basisschwingung von der Verstärkerschaltung ausgegeben wird; und sowohl die erste Verteilerdiode als auch die zweite Verteilerdiode sind zur Eingabe des Oszillationssignals vom Kollektor des Oszillationstransistors hin zur Verstärkerschaltung AUS -geschaltet, wenn die sekundäre Oberschwingung von der Verstärkerschaltung ausgegeben wird.

3. Oszillator nach Anspruch 1 oder 2, wobei die Signaldämpfungseinrichtung einen Reihenresonanzkreis umfasst, der mit der Frequenz der Basisschwingung mitschwingt, und der eine dritte Verteilerdiode (12c) in einer Reihenschaltung mit dem Reihenresonanzkreis einschließt, und wobei die Signaldämpfungseinrichtung zwischen dem Eingangsanschluss der Verstärkerschaltung und der Masse verbunden ist, um die dritte Verteilerdiode einsatzbereit in Verbindung mit der ersten Verteilerdiode EIN -zuschalten und die zweite Verteilerdiode nur, wenn der Verstärker die sekundäre Oberschwingung ausgibt.

## Revendications

1. Un oscillateur, comprenant: un circuit oscillateur (1) qui oscille dans une bande de fréquence prédéterminée, comprenant une onde de base et au moins une onde harmonique secondaire; un moyen d'atténuation de signal; (12) pour atténuer l'onde de base seulement; et un circuit amplificateur (10) pour la sortie de l'onde de base ou l'onde harmonique secondaire d'un signal d'oscillation comprenant l'onde de base et l'onde harmonique secondaire sorties du circuit oscillateur; **caractérisé en ce que** la borne d'entrée du circuit amplificateur est pourvue d'un moyen d'atténuation de signal, et **en ce que** le moyen d'atténuation de signal est coupé à ARRÊT pour l'entrée du signal d'oscillation dans le circuit amplificateur quand l'onde de base est sortie du circuit amplificateur, et le moyen d'atténuation du signal est mis sur MARCHE pour atténuer l'onde de base quand le signal harmonique secondaire est sorti du circuit amplificateur.

2. Un oscillateur selon la revendication 1, dans lequel le circuit oscillateur comprend un transistor oscillateur (2), une première diode (11b) de commutation est connectée entre le commutateur du transistor oscillateur et la terre, et l'émetteur du transistor d'oscillation est accouplé avec la borne d'entrée du circuit amplificateur par une deuxième diode de commutation (11d); la première diode de commutation ainsi que la deuxième diode de commutation sont mises en MARCHE pour faire entrer le signal d'oscillation provenant de l'émetteur du transistor d'oscillation dans le circuit amplificateur quand l'onde de base est sortie du circuit amplificateur; et la première diode de commutation ainsi que la deuxième diode de commutation sont mises sur ARRET pour faire entrer le signal d'oscillation du commutateur du transistor d'oscillation au circuit amplificateur quand l'onde harmonique secondaire est sortie du circuit amplificateur.

3. Un oscillateur selon la revendication 1 ou 2, dans lequel le moyen d'atténuation de signal comprend un circuit de résonance sériel qui résonne avec la fréquence de l'onde de base, et une troisième diode de commutation (12c) en connexion sérielle avec le circuit de résonance sériel, et dans lequel le moyen d'atténuation de signal est connecté entre la home d'entrée du circuit amplificateur et la terre pour mettre en MARCHE la troisième diode de commutation opérationnellement en association avec la première diode de commutation et la deuxième diode de commutation seulement quand l'amplificateur met en sortie l'onde harmonique secondaire.
